# EUROPÄISCHE PATENTSCHRIFT

(11) **EP 2 225 809 B1**
(45) Veröffentlichungstag und Bekanntmachung des Hinweises auf die Patenterteilung: **19.10.2016**
(21) Anmeldenummer: 08865817.4
(22) Anmeldetag: 24.11.2008
(51) Int. Cl.: H01S 5/022, H01S 5/024, H05K 5/00

(54) **KOMPAKTGEHÄUSE**
COMPACT HOUSING
BOÎTIER COMPACT

(30) Priorität: 21.12.2007 DE 102007062047
(43) Veröffentlichungstag der Anmeldung: 08.09.2010
(73) Patentinhaber: OSRAM Opto Semiconductors GmbH, 93055 Regensburg (DE)
(72) Erfinder: SCHWARZ, Thomas, 93055 Regensburg (DE); STEEGMÜLLER, Ulrich, 93055 Regensburg (DE); KÜHNELT, Michael, 93051 Regensburg (DE); SCHULZ, Roland, 93059 Regensburg (DE)
(74) Vertreter: Epping - Hermann - Fischer
(86) Internationale Anmeldenummer: PCT/DE2008/001954
(87) Internationale Veröffentlichungsnummer: WO 2009/079970

(56) Entgegenhaltungen:
- EP-A- 1 241 752
- EP-A2- 1 126 526
- WO-A-01/43167
- WO-A-96/34434
- DE-A1- 19 823 691
- US-A1- 2006 029 114
- US-A1- 2006 164 817

## Beschreibung

Die Erfindung betrifft ein Kompaktgehäuse mit einer Montageplatte, einem Gehäusedeckel, einer elektrischen Durchführung sowie einem elektromagnetische Strahlung emittierenden Modul.

Licht aus kompakten Quellen wird heutzutage in Beleuchtungselementen für Displays eingesetzt oder auch für Projektionsanwendungen benötigt. Gewünscht werden möglichst kleine Quellen bei möglichst hohen Leuchtintensitäten. Daraus resultieren pro gegebenem Quellenvolumen große Leistungsdichten. Aufgrund des endlichen Wirkungsgrades entsteht im Betrieb einer solchen Lichtquelle immer Abwärme. Diese Abwärme muss beispielsweise über das Gehäuse der Lichtquelle abgeführt werden. Aufgrund ihrer hervorragenden Eigenschaften wie etwa gute Kollimierbarkeit sind Laser in Beleuchtungsquellen weit verbreitet. Insbesondere Halbleiterlaser oder mit Halbleiterelementen gepumpte Festkörperlaser finden aufgrund ihrer oft kompakten Bauweise und guten Handhabbarkeit breite Anwendungen. Werden Laserlichtquellen verschiedener Farben, insbesondere rot, grün und blau, kombiniert, so lassen sich auch für viele Anwendungen relevante, sogenannte RGB-Module herstellen. Mit RGB-Modulen lässt sich auch eine vielzahl an Farbeindrücken, unter anderem auch weißes Licht, generieren. Laserlichtquellen stellen im allgemeinen höhere Anforderungen an die Temperierung bzw. Temperaturstabilität ihres Gehäuses als andere Lichtquellen. Auch sind Laser oft empfindlich gegenüber Feuchtigkeit, Staub oder mechanischer Belastung, und benötigen des Weiteren eine stabile Plattform etwa für die Montage von Optiken oder weiterer Bauteile wie elektronischen Schaltungen. Dabei soll der Platzbedarf der Lichtquelle klein sein, um eine vielfältige Einsetzbarkeit zu gewährleisten. Trotz dieser komplexen Anforderungen sollen die Herstellungskosten für eine Lichtquelle möglichst gering sein, was unter anderem einen möglichst einfachen Aufbau der Quelle bedingt.

In der Druckschrift DE 198 23 691 A1 ist eine Gehäuseanordnung für ein Lasermodul offenbart.

Die Druckschrift WO 01/43167 A2 betrifft eine Keramik-Metall-Gehäusetechnologie.

Eine temperaturstabilisierte Laseranordnung ist in der Druckschrift WO 96/34434 A1 beschrieben.

Ein Halbleiterlaserbauteil ist in der Druckschrift US 2006/0029114 A1 angegeben.

In der Druckschrift US 2006/0164817 A1 ist ein Kommunikationsmodul erläutert.

Es betrifft die Druckschrift EP 1 241 752 A2 eine Lichtquelle mit einer Mehrzahl von Laserdiodenmodulen.

Die Druckschrift EP 1 126 526 A2 beschäftigt sich mit einem Licht emittierenden Bauteil und mit einem optischen Modul, das ein solches Bauteil umfasst.

Aufgabe der Erfindung ist es, ein Kompaktgehäuse mit einem elektromagnetische Strahlung emittierenden Modul bereitzustellen, das dem im Kompaktgehäuse befindlichen Modul mit einfachen mitteln einen verbesserten Schutz gewährt.

Diese Aufgabe wird durch die im Patentanspruch 1 angegebenen Maßnahmen gelöst. Weitere vorteilhafte Ausgestaltungen sind in den untergeordneten Patentansprüchen angegeben.

Das Kompaktgehäuse umfasst eine einstückige, aus einem metallischen Material gebildete Montageplatte, die dazu ausgestaltet ist, mit einer Hauptseite thermisch leitfähig mit einem externen, nicht zum Kompaktgehäuse gehörigen Träger verbunden zu werden. Des Weiteren weist das Kompaktgehäuse einen einstückigen Gehäusedeckel auf, der permanent mit der Montageplatte verbunden ist und mit ihr ein Volumen einschließt. Außerdem beinhaltet das Kompaktgehäuse mindestens eine elektrische Durchführung, so dass damit mindestens eine elektrisch leitende Verbindung von innerhalb des Volumens nach außerhalb des Volumens hergestellt werden kann, wobei diese Verbindung von der Montageplatte elektrisch isoliert ist. Im Volumen befindet sich ein Modul, das dazu ausgestaltet ist, elektromagnetische Strahlung zu emittieren. Dieses Modul ist direkt auf die Montageplatte aufgebracht, so dass die Verbindungsfläche zwischen Montageplatte und Modul im Wesentlichen, das heißt im Rahmen der Herstellungstoleranzen, parallel zur mit dem externen Träger verbundenen Hauptseite der Montageplatte ist. Solch ein Kompaktgehäuse ist einfach aufgebaut, lässt sich kosteneffizient herstellen, bietet dem Modul einen guten Schutz vor etwa Feuchtigkeit und ermöglicht ein effizientes Abführen der Abwärme bei kleinen geometrischen Abmessungen des Kompaktgehäuses.

Es ist nicht notwendig, dass das Volumen vollständig oder ausschließlich durch die Montageplatte und den Gehäusedeckel eingeschlossen ist.

Dass das Modul parallel zur Hauptseite der Montageplatte angeordnet ist kann bedeuten, dass die vom Modul erzeugte Strahlung beim Verlassen des Moduls eine Strahlachse aufweist, die, im Rahmen der Herstellungstoleranzen, parallel zur Hauptseite der Montageplatte orientiert ist. Ebenso ist es möglich, dass der Hauptseite der Montageplatte eine größte Begrenzungsfläche des Moduls zugewandt ist.

Das elektromagnetische Strahlung emittierende Modul ist ein Lasermodul. Hierdurch lässt sich die vom Modul emittierte Strahlung leicht handhaben, insbesondere kollimieren und fokussieren. Auch lassen sich hohe Lichtintensitäten realisieren.

Das Licht emittierende Modul emittiert rotes und grünes und blaues Licht. Somit lässt sich eine Projektionseinrichtung oder auch eine Beleuchtungseinrichtung für ein Display realisieren. Über eine Mischung von rotem, grünem und blauem Licht kann auch eine Vielzahl an Farbeindrücken erzeugt werden.

Durch die Ausgestaltung der Montageplatte mit einer Metallkernplatine können Leiterbahnen beziehungsweise elektrische Leitungen leicht auf dieser erstellt werden.

Eine Klebeverbindung zwischen Gehäusedeckel und Montageplatte lässt sich leicht herstellen. Außerdem kann ein elektrisch isolierendes Klebematerial verwendet werden, so dass eventuell auf der Metallkernplatine aufgebrachte, frei liegende Leiterbahnen durch das Klebematerial nicht kurzgeschlossen werden. Auch Unebenheiten zum Beispiel der Platine in den zu klebenden Bereichen können von der Klebemasse ausgeglichen werden.

Durch eine Klebemasse mit einem Silikon oder einem Epoxidharz, die die Klebeverbindung ausbildet, können besonders gasundurchlässige Klebeverbindungen hergestellt werden. Insbesondere die Diffusion von Wasserdampf durch die Klebeverbindung hindurch kann stark eingeschränkt werden.

Durch eine dreidimensionale Strukturierung der Montageplatte erhöht sich deren Gestaltungsspielraum. Insbesondere können Halte-, Montage- und/oder Kühlelemente ausgebildet werden, die es ermöglichen, etwa Optiken ohne zusätzliche zum Beispiel Spiegelhalter direkt an der Montageplatte zu befestigen. Solche dreidimensional strukturierten Montageplatten lassen sich über Verfahren wie Metal Injection Melting, auch als MIM bezeichnet, Fräsen oder Druckgießen leicht herstellen.

Sind Montageplatte und Gehäusedeckel aus dem gleichen Material gefertigt, reduziert sich der Fertigungsaufwand. Insbesondere können beide Teile ohne großen Aufwand miteinander verbunden werden.

Ist der Gehäusedeckel aus einem Material ausgestaltet, das zumindest in einem Spektralbereich, in dem das Modul elektromagnetische Strahlung emittiert, transparent ist, so lässt sich die emittierte Strahlung leicht aus dem Kompaktgehäuse auskoppeln.

Die elektrische Durchführung ist mit einer flexiblen Leiterplatte gebildet, die üblicher Weise einen dünnen Kern aus Polyimid aufweist, der mit Kupferstrukturen beschichtet ist und auch mehrlagig ausgeführt sein kann. Hierdurch lässt sich ebenfalls eine äußerst gasdichte Abschließung des Volumens erreichen. Durch die mechanische Flexibilität kann die Leitungsführung einfacher gehandhabt werden. Auch lässt sich eine flexible Leiterplatte kostengünstig gestalten.

Durch einen gasdichten Abschluss des Volumens wird das Modul vor Umwelteinflüssen, insbesondere vor Wasser und Wasserdampf, geschützt. Besonders bei feuchtigkeitsempfindlichen Laser- oder Halbleitermodulen erhöht sich deren Lebensdauer.

Einfach, effizient und gasdicht ist eine Verbindung zwischen Gehäusedeckel und Montageplatte, die als Löt- und/oder Schweißverbindung ausgeführt ist.

Dadurch, dass mindestens eine Treiberelektronik für das Licht emittierende Modul an der Montageplatte angebracht ist, wird eine kompakte und Platz sparende Anordnung erreicht.

Es befindet sich die Treiberelektronik im Inneren des Volumens. Dadurch ist die Treiberelektronik ebenfalls vor Umwelteinflüssen geschützt und befindet sich außerdem in räumlicher Nähe zum Modul.

Umfasst das Kompaktgehäuse eine sich außerhalb des Volumens befindliche Anschlusseinrichtung, so kann das Kompaktgehäuse ohne großen Aufwand an externe, nicht zum Kompaktgehäuse gehörige Zuleitungen angeschlossen werden.

Ist die Anschlusseinrichtung aus einem Kunststoff-Metall-Steckerelement oder einem Nullkraftstecker ausgebildet, so ist die Anschlusseinrichtung kostengünstig und kann einfach angebracht werden.

Es umfasst das Kompaktgehäuse mindestens eine elektrische Leitung, die mindestens eine elektrische Verbindung zwischen Modul und Durchführung und Treiberelektronik und/oder Anschlusseinrichtung herstellt. Somit lassen sich einfach Platz sparende elektrische Kontaktierungen zwischen diesen Bauteilen herstellen.

Es sind die elektrischen Leitungen mit einer flexiblen Leiterplatte ausgebildet oder bestehen aus einer solchen. Hierdurch reduziert sich der Aufwand für das Führen der elektrischen Leitung, da diese auf effiziente Art etwa durch Biegen weitestgehend frei im Volumen verlegt werden können.

Ist das Kompaktgehäuse so ausgestaltet, dass es zur Verwendung hochfrequenter Treiberströme für das Modul geeignet ist, so erhöhen sich dessen Anwendungsmöglichkeiten. Hochfrequent kann bedeuten, dass die Treiberströme mit einer Frequenz von mindestens 20 MHz, insbesondere von mindestens 40 MHz abstimmbar sind. Speziell sind hierdurch sogenannte Flying-Spot-Projektionen ermöglicht, für die typisch in der Größenordnung von 20 MHz bis 100 MHz getaktete Treiberströme erforderlich sind.

Eine wenig Platz beanspruchende und gleichzeitig leuchtstarke Lichtquelle wird erreicht, wenn das Kompaktgehäuse mit hohen Treiberströmen von bis zu 12 A betrieben werden kann. Insbesondere erreichen oder übersteigen die Treiberströme, wenigstens zeitweise, eine Stärke von 6 A, speziell von 10 A. Umfasst das Kompaktgehäuse eine einstückige, thermisch leitfähige, insbesondere metallische Basisplatte, die zwischen Montageplatte und einem externen, nicht zum Kompaktgehäuse gehörigen Träger angebracht ist, so erhöht sich der Ausgestaltungsspielraum des Kompaktgehäuses. Eine solche Basisplatte kann auch als Adapterplatte verwendet werden, um denselben Typ Montageplatte auf verschieden ausgestalteten externen Trägern anbringen zu können.

Weist die Basisplatte eine dreidimensionale Strukturierung auf, so dass Halte-, Montage- und/oder Kühlelemente gebildet werden, so können diese Elemente effizient und kostengünstig in das Kompaktgehäuse integriert werden.

Über eine Temperiereinheit, die das Kompaktgehäuse umfasst, lässt sich die Temperatur des elektromagnetische Strahlung emittierenden Moduls einstellen. Dadurch wird etwa eine Überhitzung des Moduls vermieden oder auch, speziell bei Halbleiterlasermodulen, ein spektrales Schieben der emittierten Strahlung verhindert oder auch gezielt ermöglicht.

Ist die Temperiereinheit mit einem Peltier-Element ausgestaltet, so lässt sich diese Platz sparend und kosteneffizient einbauen. Außerdem ist die Temperiereinheit elektrisch betreibbar sowie genau und einfach regelbar.

Durch das thermisch leitfähige Anbringen der Kaltseite des Peltier-Elements an der Montageplatte und der Heißseite an der Basisplatte lassen sich Heiß- und Kaltseiten des Peltier-Elements thermisch gut entkoppeln und eine effiziente Abführung der Verlustleistung des Peltier-Elements nach außen an einen externen, nicht zum Kompaktgehäuse gehörigen Träger gewährleisten, ohne die Temperierung des Moduls negativ zu beeinflussen.

Erfolgt die permanente Verbindung zwischen Gehäusedeckel und Montageplatte indirekt über Basisplatte und Peltier-Element, so erhöhen sich die Ausgestaltungsmöglichkeiten des Kompaktgehäuses. Insbesondere wenn der Gehäusedeckel thermisch leitend an der Seite der Basisplatte angebracht ist, die mit der Heißseite des Peltier-Elements verbunden ist, vergrößert sich die nach außen hin Wärme abgebende Fläche des Kompaktgehäuses, wodurch die Kühlung effizienter wird.

Weist das Kompaktgehäuse ein Lichtaustrittsfenster auf, das mindestens für einen Teil der vom Modul emittierten elektromagnetischen Strahlung transparent ist, kann das Licht das Kompaktgehäuse verlassen. Dies gilt insbesondere, wenn der Gehäusedeckel metallisch ausgeführt ist. Beispielsweise ist das Lichtaustrittsfenster mit SiO₂, einem Glas, einem Kunststoff oder Saphir gestaltet oder besteht aus zumindest einem der genannten Materialien.

Ist das Lichtaustrittsfenster beheizt, so kann verhindert werden, dass sich am Lichtaustrittsfenster Wasser beziehungsweise Wasserdampf niederschlägt und einen Austritt des Lichts aus dem Kompaktgehäuse behindert. Insbesondere gilt dies, wenn das Lichtaustrittsfenster mit der Kaltseite eines Peltier-Elements in thermischem Kontakt steht.

Ist das Lichtaustrittsfenster so ausgestaltet, dass es eine optisch diffraktive, refraktive oder filternde Wirkung auf zumindest einen Teil der von einem im Volumen befindlichen Modul emittierten Strahlung ausübt, so lässt sich die Anzahl an optischen Komponenten, die auf der Montageplatte anzubringen sind, reduzieren. Dadurch wird auch der Platzbedarf des Kompaktgehäuses verringert.

Über eine Feuchtigkeitsfalle im Volumen kann eventuell in das Volumen eindringende Feuchtigkeit vom Modul abgehalten werden.

Die Feuchtigkeitsfalle kann eine hydrophile bzw. wasserziehende Substanz, wie etwa ein Zeolith oder ein Kalzium- oder Bariumoxid, beinhalten. Ebenso ist es möglich, die Feuchtigkeitsfalle als Kältefalle auszugestalten.

Nachfolgend wird die Erfindung unter Bezugnahme auf die Zeichnung anhand von Ausführungsbeispielen beschrieben. Gleiche Bezugszeichen geben dabei gleiche Elemente in den einzelnen Figuren an. Es sind dabei jedoch keine maßstäblichen Bezüge dargestellt.

Es zeigen:
- Figur 1: eine schematische Darstellung eines Ausführungsbeispiels eines Kompaktgehäuses,
- Figur 2: eine Seitenansicht a) und eine Draufsicht b) einer Abwandlung eines Kompaktgehäuses, wobei die Montageplatte aus einer Metallkernplatine ausgestaltet ist,
- Figur 3: eine Seitenansicht a) und eine Draufsicht b) eines Ausführungsbeispiels eines Kompaktgehäuses, wobei die Montageplatte aus einer mit dreidimensionalen Strukturen versehenen metallischen Platte ausgestaltet ist,
- Figur 4: eine Seitenansicht eines weiteren Ausführungsbeispiels eines Kompaktgehäuses,
- Figur 5: eine Draufsicht eines Ausführungsbeispiels mit mehreren Modulen und mit einer Feuchtigkeitsfalle,
- Figur 6: eine Seitenansicht eines Ausführungsbeispiels mit einem Peltier-Element und einer Basisplatte,
- Figur 7: eine Seitenansicht einer Abwandlung mit einer Multilagenkeramik als elektrischer Durchführung, und
- Figur 8: ein Ausführungsbeispiel mit einem beheiztem Lichtaustrittsfenster.

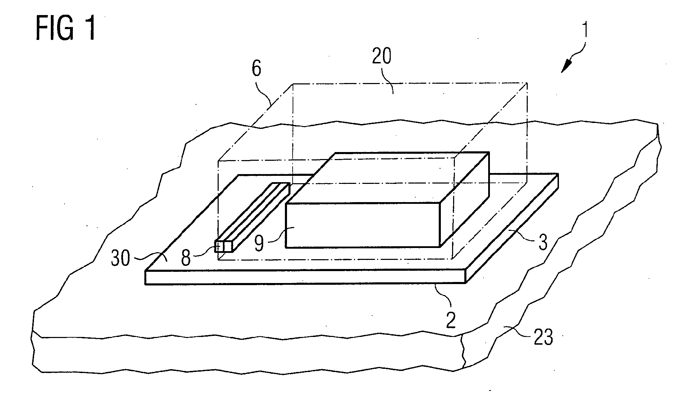

In Figur 1 ist ein Ausführungsbeispiel eines Kompaktgehäuses 1 gezeigt. Eine metallische, thermisch leitfähige Montageplatte 3 ist im Wesentlichen flächig ausgeprägt und rechteckig gestaltet. Als Materialien mit hoher Wärmeleitfähigkeit kommen für die Montageplatte 3 zum Beispiel Kupfer, Aluminium, CuW oder MoCu in Frage. Eine Hauptseite 2 der Montageplatte 3 ist thermisch leitfähig mit einem externen Träger 23, der nicht Bestandteil des Kompaktgehäuse 1 ist, verbunden. Auf der der Hauptseite 2 gegenüberliegenden Seite der Montageplatte 3 befindet sich eine Montageseite 30. Hauptseite 2 und Montageseite 30 sind im Wesentlichen parallel zueinander. Auf der Montageseite 30 ist ein Gehäusedeckel 6 über eine Lötverbindung angebracht. Gehäusedeckel 6 und Montageplatte 3 schließen ein Volumen 20 ein. Der Gehäusedeckel 6 ist in diesem Ausführungsbeispiel transparent ausgestaltet. Im Volumen 20 befindet sich ein elektromagnetische Strahlung emittierendes Modul 9, das direkt mit der Montageseite 30 der Montageplatte 3 thermisch leitend verbunden ist. Ebenfalls an der Montageseite 30 angebracht ist eine elektrische Durchführung 8. Die elektrische Durchführung befindet sich zwischen Gehäusedeckel 6 und Montageplatte 3 und ist mit diesen rundherum, in einer Ebene senkrecht zur Montageseite 30, verlötet, so dass das Volumen 20 gasdicht abgeschlossen ist. Im Bereich der Durchführung 8 hat der Gehäusedeckel 6 somit keinen direkten Kontakt zur Montageplatte 3.

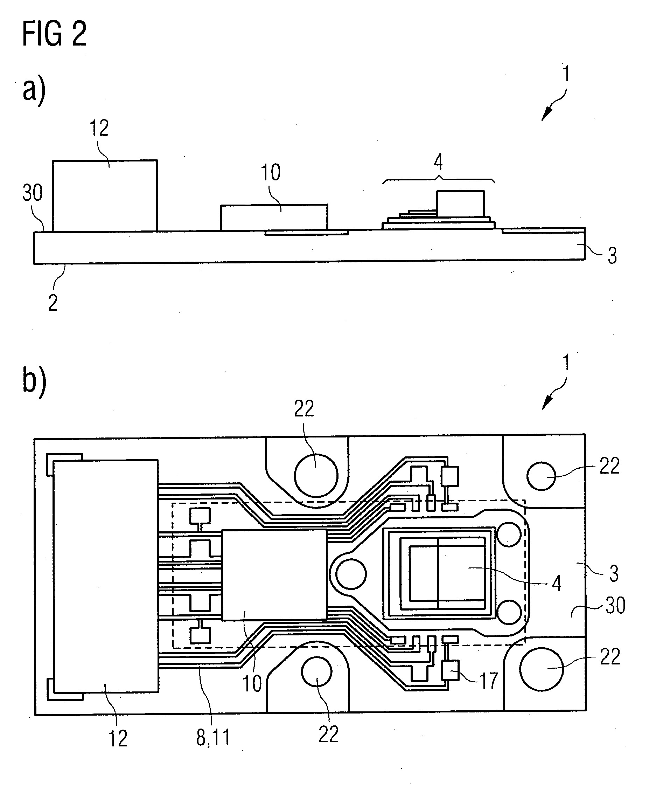

In Figur 2 ist eine Abwandlung eines Kompaktgehäuses 1 schematisch dargestellt. Zur Vereinfachung der Darstellung wurde der Gehäusedeckel 6 hier nicht eingezeichnet. Die Linie, entlang der der Gehäusedeckel 6 mit der Montageplatte 3 verbunden ist, ist strichliert angedeutet. Die im wesentlichen flächige, ebene Montageplatte 3 ist aus einer Metallkernplatine ausgestaltet. Die Metallkernplatine weist einen metallischen Kern auf, der eine Dicke von einigen Millimetern hat und der von einer dünnen Polyimidschicht ummantelt ist. Auf diesen Polyimidmantel wiederum ist eine Schicht aus Kupfer aufgebracht, aus der beispielsweise über Ätzprozesse wie bei einer gewöhnliche Leiterplatte die elektrischen Leitungen 11 ausgestaltet sind. Die Metallkernplatine vereint daher einerseits leichte Fertigbarkeit bezüglich der Leitungen 11 als auch hohe thermische Leitfähigkeit aufgrund des Metallkerns. Da die Polyimidschicht sehr dünn ist, typischerweise unter 100 Mikrometer, stellt diese keine großen thermischen Widerstand dar. Trotzdem wurde in Bereichen, in denen das Modul 9, das hier als Lasermodul 4 ausgestaltet ist, mit der Montageplatte 3 verbunden ist, die Polyimidschicht von der Montageseite 30 entfernt, um einen direkten Kontakt zum Metallkern der Platine herzustellen.

Zusätzlich zum Lasermodul 4 wurden auf der Montageseite 30 noch eine Treiberelektronik 10 sowie eine elektrische Anschlusseinrichtung 12 angebracht. Die sich an der Montageseite 30 befindlichen elektrischen Leitungen 11 sind so strukturiert, dass sie geeignete elektrisch Verbindungen zwischen Anschlusseinrichtung 12, Treiberelektronik 10 und Lasermodul 4 herstellen. Zusätzlich sind an den Leiterbahnen Lötpads 17 vorgesehen, um weitere Kontaktierungen, etwa zur der Montageseite 30 abgewandten Seite des Lasermoduls 4, zu ermöglichen. Die elektrischen Leitungen 11 bilden gleichzeitig die elektrische Durchführung 8 aus, da aufgrund der sehr geringen Höhe der elektrischen Leitungen 11 auf der Montageseite 30 der Gehäusedeckel 6 über einen elektrisch isolierenden Klebstoff einfach auf der Montageseite 30 aufgeklebt werden kann.

Die elektrische Anschlusseinrichtung 12 ist als Metall-Kunststoffstecker ausgestaltet, der ein verbreitetes Bauteil in der Elektronik darstellt und kostengünstig ist. Außerdem ist eine einfache Kontaktierung dieser Anschlusseinrichtung 12 mit hier nicht eingezeichneten externen Zuleitungen möglich. Um das Kompaktgehäuse 1 an einem nicht gezeichneten externen Träger befestigen zu können, wurden an der Montageplatte 3 Befestigungsvorrichtungen 22 in Form von Bohrlöchern angebracht, über die das Kompaktgehäuse 1 an einem externen Träger angeschraubt werden kann. Ohne Einschränkung auf andere Ausführungsbeispiele der Erfindung beträgt die Größe des Kompaktgehäuses 1 gemäß Figur 2, wie in den anderen Ausführungsbeispielen, lateral weniger als 30 mal 30 Millimeter, die Höhe beträgt einige Millimeter.

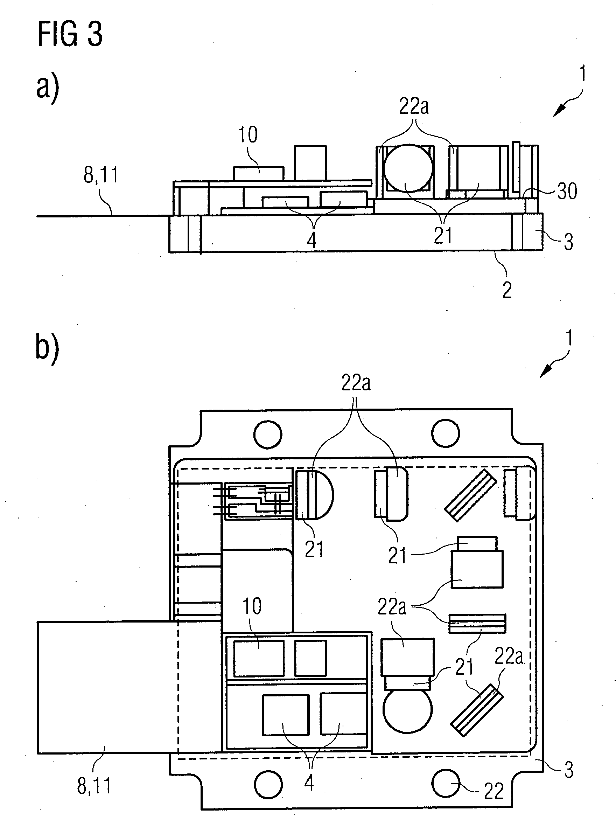

Im weiteren Ausführungsbeispiel gemäß Figur 3 ist aus Gründen der Übersichtlichkeit der Gehäusedeckel 6 erneut nicht eingezeichnet, die Verbindung zur Montageplatte 3 ist wieder als Strichlinie angedeutet. Die Strahlwege des vom Laserlicht emittierenden Moduls 4 sind als Strich-Punkt-Linien symbolisiert. Die einstückige, aus einem metallischen Werkstoff gefertigte, eine hohe Wärmeleitfähigkeit aufweisende Montageplatte 3 ist mit komplexeren dreidimensionalen Strukturierungen versehen. Durch diese Strukturierungen werden Befestigungseinrichtungen 22a beispielsweise für optische Komponenten 21 wie Linsen, Filter oder Spiegel ausgeformt, so dass diese Komponenten direkt und über die Formgebung der Montageplatte 3 bereits vorjustiert auf dieser angebracht werden können. Auch besteht erneut die Möglichkeit, die Montageplatte 3 an einem externen Träger über dafür vorgesehene Befestigungseinrichtungen 22 festzuschrauben. Das Kompaktgehäuse 1 umfasst auch eine Treiberelektronik 10, die sich im Inneren des von Montageplatte 3 und Gehäusedeckel 6 eingeschlossenen Volumens 20 befindet. Elektrische Leitungen 11 und elektrische Durchführungen 8 sind aus einer flexiblen Leiterplatte ausgestaltet. Die flexible Leiterplatte besteht aus einem flachen Band aus typischerweise Polyimid, dessen Dicke um 100 Mikrometer beträgt. Auf diesem Polyimidband sind Leiterstrukturen etwa aus Kupfer angebracht. Diese Kupferbahnen können durch Lötschutzlack oder auch durch eine weitere Lage Polyimid abgedeckt werden. Auch ein mehrere Kupfer- und Polyimidlagen aufweisender Aufbau der flexiblen Leiterplatte ist möglich. Um ein gasdichtes Gehäuse zu erzielen, können ebenfalls flexible Leiterplatten verwendet werden, welche in den hierfür erforderlichen Bereichen als äußeren Mantel eine durchgehende lötbare Kupferschicht aufweisen, die mit Montageplatte 3 beziehungsweise Gehäusedeckel 6 verlötet oder verschweißt werden kann.

Montageplatten 3 mit dreidimensionalen Strukturierungen lassen sich über Verfahren wie Metal Injection Melting, abgekürzt MIM, Fräsen oder Druckgießen mit verhältnismäßig geringem Aufwand herstellen. Die dreidimensionale Strukturierung erspart das Anbringen zusätzlicher Komponenten wie etwa Spiegelhalter oder Linsen. Gleichzeitig können die Befestigungsvorrichtungen so strukturiert sein, dass eine aufwändige Justage der optischen Komponenten weitestgehend entfällt, da diese Komponenten bereits passend an der Montageplatte 3 platziert sind. Auch etwa Blenden oder Anschläge lassen sich mitstrukturieren, was eine Justage der Optiken ebenfalls vereinfacht. Anders als in Figur 3 gezeigt, muss sich die elektrische Durchführung 8 nicht zwischen Montageplatte 3 und Gehäusedeckel 6 befinden, sondern kann zum Beispiel in einer Aussparung des Gehäusedeckels 6 angebracht sein.

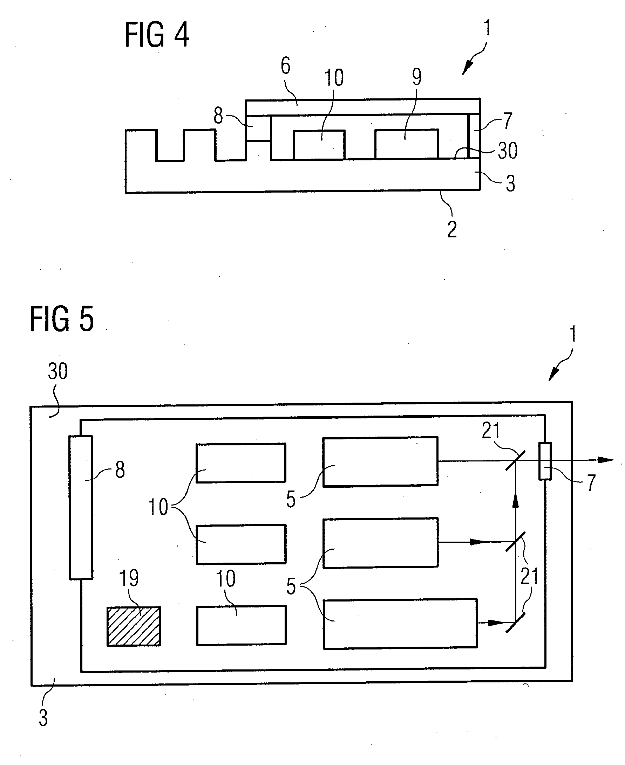

Beim Ausführungsbeispiel gemäß Figur 4, das wieder ein Licht emittierendes Modul 9, eine Montageplatte 3 und einen flachen, ebenen Gehäusedeckel 6 einer einfachen Geometrie umfasst, ist die Montageplatte 3 mit Kühlrippen versehen. Dies erleichtert ein Abführen der Betriebswärme des Moduls 9 nach außen und erspart aufwändigere Kühlvorrichtungen. Zur Auskopplung des Lichts aus dem Kompaktgehäuse 1 ist ein Lichtaustrittsfenster 7 in dieses integriert.

Optional kann das Lichtaustrittsfenster 7 gleichzeitig als optische Komponente verwendet werden, etwa als fokussierendes oder defokussierendes Element, oder kann, wenn etwa mit einer dielektrischen oder einer absorbierenden Schicht versehen, auch als Filter wirken. Je nach Erfordernissen können auch mehrere möglicherweise unterschiedlich funktionalisierte Lichtaustrittsfenster 7 verwendet werden. Über eine geeignete Strahlführung im Inneren des Kompaktgehäuses 1 beziehungsweise über geeignete Treiberelektronik 10 können auch abwechselnd verschiedene Lichtaustrittsfenster 7 zur Lichtauskopplung aus dem Kompaktgehäuse 1 benützt werden, etwa um unterschiedliche Lichtintensitäten, Strahllagen oder Farbgebungen zu realisieren.

Ein Ausführungsbeispiel mit mehreren emittierenden Modulen ist schematisch in Figur 5 gezeigt. Erneut wurde der Gehäusedeckel 6 nicht eingezeichnet. Vereinfacht sind Lasermodule und Optiken als eine Einheit 5 dargestellt. Die drei Einheiten 5 können rotes, grünes und blaues Licht abstrahlen und ergeben dadurch insgesamt ein so genanntes RGB-Modul, das etwa für Projektionsanwendungen Verwendung finden kann. Das Licht aus den drei Einheiten 5, symbolisiert durch gepfeilte Linien, wird kombiniert und verlässt das Kompaktgehäuse 1 über ein Lichtaustrittsfenster 7. Die zu den Einheiten 5 gehörigen Treiberelektroniken 10 sind im Volumen 20 des Kompaktgehäuses 1 untergebracht. Im Volumen 20 ist ebenfalls eine Feuchtigkeitsfalle 19 integriert. Diese verhindert bei Auftreten etwa einer Undichtigkeit der Verbindung zwischen Montageplatte 3 und Gehäusedeckel 6, dass sich die Feuchtigkeit an den wasserempfindlichen Einheiten 5 ansammelt, sondern in der Feuchtigkeitsfalle niederschlägt. Die Feuchtigkeitsfalle kann ein Trockenmittel beinhalten wie etwa ein Zeolith. Es ist möglich, den Gehäusedeckel 6 so zu gestalten, dass ein einfaches Austauschen bzw. Erneuern des Trockenmittels etwa über eine gasdicht verschraubbare Öffnung möglich ist.

Bei geeigneter Ausgestaltung des Kompaktgehäuses 1, insbesondere wenn der Gehäusedeckel 6 elektrisch leitend mit der Montageplatte 3 verbunden ist und sich daraus eine elektronische Abschirmung ergibt, kann ein hochfrequenztaugliches Kompaktgehäuse 1 entstehen. Für Projektionsanwendungen werden etwa getaktete Treiberströme mit Taktfrequenzen im Bereich von 20 bis 100 Megahertz benötigt. Diese Hochfrequenztauglichkeit kann durch impedanzangepasste Stromzuführung mit geeignet ausgestalteten flexiblen Leiterbahnen, die elektrische Leitungen 11 ausbilden, in Kombination mit so genannten Nullkraftsteckern als Anschlusseinrichtung 12 erfolgen. Ist eine Verwendung als Displaybeleuchtung vorgesehen, wo die roten, gelben beziehungsweise blauen Lichtanteile des von den Einheiten 5 emittierten Lichts durch eine Maske gefiltert werden und meist große Lichtintensitäten und somit elektrische Leistungsdichten erforderlich sind, ist es über passend gestaltete, die Leitungen 11 bildende flexible Leiterplatten auch möglich, sehr hohe Treiberströme im Bereich bis zu zwölf Ampere verlustarm zu führen und damit derart große elektrische Ströme zu verwenden.

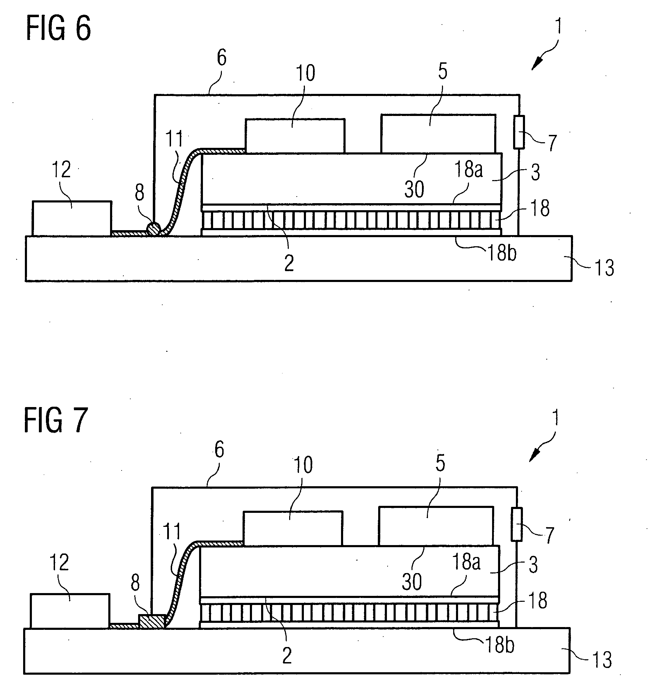

In Figur 6 ist ein Ausführungsbeispiel des Kompaktgehäuses 1 gezeigt, das eine Temperiereinheit 16 in Form eines Peltier-Elements 18 umfasst. Die Kaltseite 18a des Peltier-Elements 18 ist mit der Montageplatte 3 verbunden, die Heißseite 18b mit der Basisplatte 13. Hierdurch ist es ermöglicht, die sich auf der Montageseite 30 befindliche Einheit 5, bestehend aus Lasermodul und Optiken, konstant auf einer geeigneten Temperatur zu halten. Auch die Treiberelektronik 10 kann mit temperiert werden. Der Gehäusedeckel 6 ist mit der Basisplatte 13 verlötet. Die elektrische Durchführung 8 ist, wie im Ausführungsbeispiel gemäß Figur 3, als flexible Leiterbahn ausgestaltet. Die Anschlusseinrichtungen 12 zu nicht gezeichneten externen Leitungen sind als Metall-Kunststoffstecker ausgeführt. Da der Gehäusedeckel 6 mit der Heißseite 18b des Peltier-Elements 18 über die Basisplatte 13 verbunden ist, ist die Temperatur des Gehäusedeckels 6 im Vergleich zur Umgebung, zur Montageplatte 3 und den sich auf der Montageseite 30 befindlichen Komponenten erhöht, so dass sich keine Feuchtigkeit am Lichtaustrittsfenster 7 niederschlägt und das Licht unbeeinträchtigt das Kompaktgehäuse 1 verlassen kann.

Die Abwandlung gemäß Figur 7 entspricht dem Ausführungsbeispiel gemäß Figur 6, als elektrische Durchführung 8 dient hier allerdings eine Multilagenkeramik. Hierbei sind elektrische Durchkontaktierungen aus zum Beispiel Kupfer in eine keramische Substanz wie etwa Aluminiumnitrid eingebettet. Mehrere sich abwechselnde Lagen Keramik und Kupfer sind realisierbar. Das gesamte Bauteil wird durch Sintern erstellt. Durch eine äußere Beschichtung aus etwa Kupfer kann die Multilagenkeramik ringsum, analog zum Ausführungsbeispiel gemäß Figur 1, eingelötet oder eingeschweißt werden, so dass insgesamt eine äußerst gasdichte elektrische Durchführung resultiert.

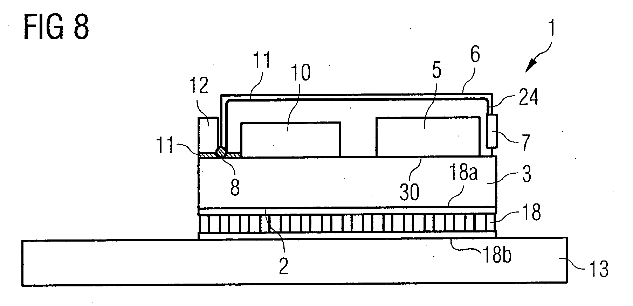

Beim Ausführungsbeispiel gemäß Figur 8 ist der Gehäusedeckel 6 an der Montageplatte 3 angebracht, die thermischen Kontakt zur Kaltseite 18a des Peltier-Elements 18 aufweist. Dadurch ist die Temperatur des Gehäusedeckels 6 im Vergleich zur Umgebung ebenfalls erniedrigt, so dass ein Beschlagen des am Gehäusedeckel 6 angebrachten und somit ebenfalls kälteren Lichtaustrittsfensters 7 möglich ist. Um dies zu vermeiden, wird das Lichtaustrittsfenster 7 beheizt, indem eine flexible Leitung 11 zu einem am Lichtaustrittsfenster 7 befindlichen Heizwiderstand geführt ist.

Selbstverständlich können die verschiedenen Varianten für die Ausgestaltungen der elektrischen Durchführungen 8, der Platzierung der Treiberelektronik 10, der elektrischen Leitungen 11 und der Ausformung der Montageplatte 3, wie sie in den verschieden Ausführungsbeispielen gezeigt wurden, miteinander kombiniert werden. Auch die Anzahl von zum Beispiel Licht emittierenden Modulen 9, Peltier-Elementen 18 oder Feuchtigkeitsfallen 19, die das Kompaktgehäuse 1 umfasst, kann von der in den gezeigten Ausführungsbeispielen abweichen.

## Patentansprüche

1. Kompaktgehäuse (1) zum Schutz eines Lasermoduls vor Staub, Feuchtigkeit und mechanischen Belastungen mit
- mindestens einem Lasermodul (4), das rotes, grünes und blaues Licht emittiert,
- einer einstückigen Montageplatte (3), die aus einem metallischen Material gebildet und dazu ausgestaltet ist, mit einer Hauptseite (2) thermisch leitfähig mit einem externen Träger verbunden zu werden,
- einem einstückigen Gehäusedeckel (6), der permanent mit der Montageplatte (3) verbunden ist und mit ihr ein Volumen (20) einschließt, und
- mindestens einer elektrischen Durchführung (8), mittels der zumindest eine elektrisch leitende Verbindung von innerhalb des Volumens (20) nach außerhalb des Volumens (20) hergestellt wird, wobei diese Verbindung von der Montageplatte (3) elektrisch isoliert ist,
wobei das mindestens eine Lasermodul (4) sich in dem Volumen (20) befindet und parallel zur Hauptseite (2) auf die Montageplatte (3) aufgebracht ist,
**dadurch gekennzeichnet, dass**
- an der Montageplatte (3) mindestens eine Treiberelektronik (10) für das mindestens eine Modul (9) angebracht ist und sich die Treiberelektronik (10) im Inneren des Volumens (20) befindet,
- die Durchführung (8) und eine elektrische Leitung (11), die mindestens eine elektrische Verbindung zwischen der Durchführung (8) und dem wenigstens einen Modul (9) sowie der Treiberelektronik (10) herstellt, jeweils mindestens eine flexible Leiterplatte umfassen, und
- der Gehäusedeckel (6) mittels einer Klebeverbindung, mittels einer Schweißverbindung oder mittels einer Lötverbindung an der Montageplatte (3) befestigt ist.

2. Kompaktgehäuse (1) nach Anspruch 1,
das mit Treiberströmen von bis zu 12 A betreibbar ist.

3. Kompaktgehäuse (1) nach Anspruch 1 oder 2,
wobei die Montageplatte (3) eine Metallkernplatine umfasst oder aus einer solchen besteht.

4. Kompaktgehäuse (1) nach einem der vorhergehenden Ansprüche,
wobei die Montageplatte (3) dreidimensionale Strukturierungen aufweist, so dass Halte-, Montage- und/oder Kühlelemente gebildet sind.

5. Kompaktgehäuse (1) nach einem der vorhergehenden Ansprüche,
wobei die Montageplatte (3) und der Gehäusedeckel (6) aus dem gleichen Material bestehen.

6. Kompaktgehäuse (1) nach einem der Ansprüche 1 bis 4, dessen Gehäusedeckel (6) aus einem transparenten Material ausgestaltet ist.

7. Kompaktgehäuse (1) nach einem der vorhergehenden Ansprüche, wobei die elektrische Leitung (11) und die Durchführung (8) aus einer flexiblen Leiterplatte ausgestaltet sind und die flexible Leiterplatte mehrere Polyimidlagen und mehrere Kupferlagen aufweist.

8. Kompaktgehäuse (1) nach einem der vorhergehenden Ansprüche, wobei die elektrische Leitung (11) gleichzeitig die Durchführung (8) bildet.

9. Kompaktgehäuse (1) nach dem vorhergehenden Anspruch, wobei der Gehäusedeckel (6) elektrisch leitend mit der Montageplatte (3) verbunden ist und als elektronische Abschirmung dient.

10. Kompaktgehäuse (1) nach einem der vorhergehenden Ansprüche,
wobei das Volumen (20) gasdicht abgeschlossen ist.

11. Kompaktgehäuse (1) nach dem vorhergehenden Anspruch und nach Anspruch 8 oder 9, wobei die flexible Leiterplatte in einem Bereich, in dem die flexible Leiterplatte mit der Montageplatte (3) beziehungsweise mit dem Gehäusedeckel (6) verlötet oder verschweißt ist, einen äußeren Mantel mit einer durchgehenden Kupferschicht aufweist.

12. Kompaktgehäuse (1) nach einem der vorhergehenden Ansprüche,
das eine einstückige thermisch leitfähige metallische Basisplatte (13) umfasst, die zwischen Montageplatte (3) und einem externen Träger angebracht ist, wobei die Basisplatte (13) mindestens eine dreidimensionale Strukturierung aufweist, so dass Halte-, Montage- und/oder Kühlelemente gebildet sind.

13. Kompaktgehäuse (1) nach einem der vorhergehenden Ansprüche,
das mindestens ein mit einem Feststoff gebildetes Lichtaustrittsfenster (7) umfasst, das mindestens für einen Teil der vom Modul (9) emittierten Strahlung transparent ist, und wobei das Lichtaustrittsfenster (7) beheizt ist.

14. Kompaktgehäuse (1) nach einem der vorhergehenden Ansprüche,
bei dem sich im Volumen (20) eine Feuchtigkeitsfalle (14) befindet, wobei die Feuchtigkeitsfalle (14) eine hydrophile Substanz beinhaltet oder als Kältefalle ausgestaltet ist.

## Claims

1. Compact housing (1) for protecting a laser module against dust, moisture and mechanical loads, comprising
- at least one laser module (4) which emits red, green and blue light,
- an integral mounting plate (3) which is formed from a metal material and is designed to be thermally conductively connected to an external carrier by way of a main side (2),
- an integral housing cover (6) which is permanently connected to the mounting plate (3) and encloses a volume (20) with the said mounting plate, and
- at least one electrical bushing (8) by means of which at least one electrically conductive connection from within the volume (20) to outside the volume (20) is established, wherein this connection is electrically insulated from the mounting plate (3),
wherein the at least one laser module (4) is located in the volume (20) and is fitted onto the mounting plate (3) parallel to the main side (2),
**characterized in that**
- at least one driver electronics system (10) for the at least one module (9) is fitted on the mounting plate (3) and the driver electronics system (10) is located in the interior of the volume (20),
- the bushing (8) and an electrical line (11), which establishes at least one electrical connection between the bushing (8) and the at least one module (9) and also the driver electronics system (10), each comprise at least one flexible printed circuit, and
- the housing cover (6) is fastened to the mounting plate (3) by means of an adhesive connection, by means of a welded connection or by means of a soldered connection.

2. Compact housing (1) according to Claim 1,
which can be operated with driver currents of up to 12 A.

3. Compact housing (1) according to Claim 1 or 2,
wherein the mounting plate (3) comprises a metal-core board or consists of a metal-core board.

4. Compact housing (1) according to one of the preceding claims,
wherein the mounting plate (3) has three-dimensional structured formations, so that retaining, mounting and/or cooling elements are formed.

5. Compact housing (1) according to one of the preceding claims,
wherein the mounting plate (3) and the housing cover (6) are composed of the same material.

6. Compact housing (1) according to one of Claims 1 to 4, the housing cover (6) of the said compact housing being designed from a transparent material.

7. Compact housing (1) according to one of the preceding claims,
wherein the electrical line (11) and the bushing (8) are designed from a flexible printed circuit, and the flexible printed circuit has a plurality of polyimide layers and a plurality of copper layers.

8. Compact housing (1) according to one of the preceding claims,
wherein the electrical line (11) simultaneously forms the bushing (8).

9. Compact housing (1) according to the preceding claim, wherein the housing cover (6) is electrically conductively connected to the mounting plate (3) and serves as an electronic shield.

10. Compact housing (1) according to one of the preceding claims,
wherein the volume (20) is closed off in a gas-tight manner.

11. Compact housing (1) according to the preceding claim and according to Claim 8 or 9,
wherein the flexible printed circuit has, in a region in which the flexible printed circuit is soldered or welded to the mounting plate (3) or to the housing cover (6), an outer casing with a continuous copper layer.

12. Compact housing (1) according to one of the preceding claims,
which comprises an integral thermally conductive metal base plate (13) which is fitted between the mounting plate (3) and an external carrier, wherein the base plate (13) has at least one three-dimensional structured formation, so that retaining, mounting and/or cooling elements are formed.

13. Compact housing (1) according to one of the preceding claims,
which comprises at least one light exit window (7) which is formed by a solid material and which is transparent at least to some of the radiation which is emitted by the module (9), and wherein the light exit window (7) is heated.

14. Compact housing (1) according to one of the preceding claims,
in which a moisture trap (14) is located in the volume (20), wherein the moisture trap (14) contains a hydrophilic substance or is designed as a cold trap.

## Revendications

1. Boîtier compact (1) destiné à protéger un module à laser contre la poussière, l'humidité et les contraintes mécaniques, comprenant
- au moins un module à laser (4) qui émet de la lumière rouge, verte et bleue,
- une plaque de montage (3) monobloc qui est constituée d'un matériau métallique et qui est configurée pour être reliée par un côté principal (2) avec conductivité thermique à un support externe,
- un couvercle de boîtier (6) monobloc qui est relié en permanence à la plaque de montage (3) et qui, avec celle-ci, entoure un volume (20), et
- au moins une traversée électrique (8) au moyen de laquelle au moins une liaison électriquement conductrice est établie depuis l'intérieur du volume (20) vers l'extérieur du volume (20), cette liaison étant isolée électriquement de la plaque de montage (3), l'au moins un module à laser (4) se trouvant dans le volume (20) et étant monté sur la plaque de montage (3) parallèlement au côté principal (2), **caractérisé en ce que**
- au moins une électronique d'attaque (10) pour l'au moins un module (9) est montée sur la plaque de montage (3) et l'électronique d'attaque (10) se trouve à l'intérieur du volume (20),
- la traversée (8) et un câble électrique (11), lequel établit au moins une liaison électrique entre la traversée (8) et l'au moins un module (9) ainsi que l'électronique d'attaque (10), comprennent respectivement au moins un circuit imprimé souple,
et
- le couvercle de boîtier (6) est fixé à la plaque de montage (3) au moyen d'un assemblage collé, au moyen d'un assemblage soudé ou au moyen d'un assemblage brasé.

2. Boîtier compact (1) selon la revendication 1, lequel peut fonctionner avec des courants d'attaque pouvant atteindre jusqu'à 12 A.

3. Boîtier compact (1) selon la revendication 1 ou 2, la plaque de montage (3) comprenant une platine centrale métallique ou étant constituée d'une telle platine.

4. Boîtier compact (1) selon l'une des revendications précédentes, la plaque de montage (3) possédant une structuration tridimensionnelle, de sorte que des éléments de maintien, de montage et/ou de refroidissement sont formés.

5. Boîtier compact (1) selon l'une des revendications précédentes, la plaque de montage (3) et le couvercle de boîtier (6) étant constitués du même matériau.

6. Boîtier compact (1) selon l'une des revendications 1 à 4, dont le couvercle de boîtier (6) est structuré à partir d'un matériau transparent.

7. Boîtier compact (1) selon l'une des revendications précédentes, le câble électrique (11) et la traversée (8) étant structurés à partir d'un circuit imprimé souple et le circuit imprimé souple possédant plusieurs couches de polymère et plusieurs couches de cuivre.

8. Boîtier compact (1) selon l'une des revendications précédentes, le câble électrique (11) formant en même temps la traversée (8).

9. Boîtier compact (1) selon l'une des revendications précédentes, le couvercle de boîtier (6) étant relié de manière électriquement conductrice avec la plaque de montage (3) et servant de blindage électronique.

10. Boîtier compact (1) selon l'une des revendications précédentes, le volume (20) étant fermé hermétiquement aux gaz.

11. Boîtier compact (1) selon la revendication précédente et la revendication 8 ou 9, le circuit imprimé souple possédant une enveloppe externe pourvue d'une couche de cuivre ininterrompue dans une zone dans laquelle le circuit imprimé souple est brasé ou soudé avec la plaque de montage (3) ou avec le couvercle de boîtier (6).

12. Boîtier compact (1) selon l'une des revendications précédentes, lequel comprend une plaque de base (13) monobloc métallique thermoconductrice qui est disposée entre la plaque de montage (3) et un support externe, la plaque de base (13) possédant au moins une structuration tridimensionnelle, de sorte que des éléments de maintien, de montage et/ou de refroidissement sont formés.

13. Boîtier compact (1) selon l'une des revendications précédentes, lequel comprend une fenêtre de sortie de lumière (7) formée d'une matière solide, laquelle est transparente pour au moins une partie du rayonnement émis par le module (9), et la fenêtre de sortie de lumière (7) étant chauffée.

14. Boîtier compact (1) selon l'une des revendications précédentes, avec lequel un piège à humidité (14) se trouve dans le volume (20), le piège à humidité (14) contenant une substance hydrophile ou étant structuré en tant que piège à froid.
